# EUROPEAN PATENT APPLICATION

(11) **EP 4 545 225 A1**
(43) Date of publication of application: **30.04.2025**
(21) Application number: 23831315.9
(22) Date of filing: 23.06.2023
(51) Int. Cl.: B23B 27/14, B23C 5/16, C23C 14/16

(54) **COATED CUTTING TOOL**

(30) Priority: 27.06.2022 JP 2022102962
(71) Applicant: MOLDINO Tool Engineering, Ltd., Tokyo 130-0026 (JP)
(72) Inventor: ISAKA, Masakazu, Narita-shi, Chiba 286-0825 (JP); SASAKI, Tomoya, Narita-shi, Chiba 286-0825 (JP); FUWA, Ryoutarou, Yasu-shi, Shiga 520-2323 (JP)
(74) Representative: Hoffmann Eitle
(86) International application number: PCT/JP2023/023386
(87) International publication number: WO 2024/004873

(57) **Abstract**

A coated cutting tool according to an embodiment includes a substrate and a hard film that is formed on the substrate. The hard film is a nitride in which with respect to a total amount of metal elements (including metalloid), Al is 60 at% or more and 70 at% or less, Ti is 20 at% or more and 40 at% or less, and one or more selected from W, Cr, Ta, Nb, Zr, Mo, and V are 1 at% or more and 10 at% or less, and with respect to a total amount of metal elements (including metalloid), a nitrogen element, and an Ar element, Ar is contained in an amount of 0.01 at% or more and 0.15 at% or less. A crystal structure of the hard film is a face-centered cubic lattice structure, and a half-value width of an X-ray diffraction peak of a (111) plane is 0.75° or more and 0.95° or less.

## Description

### TECHNICAL FIELD

The present invention relates to a coated cutting tool.

Priority is claimed on Japanese Patent Application No.2022-102962, filed June 27, 2022, the content of which is incorporated herein by reference.

### BACKGROUND ART

In the related art, as a technology for increasing the life of a cutting tool, a surface treatment technology for coating a surface of the cutting tool with a hard film formed of various ceramics has been adopted. Among the hard films, nitride films of aluminum (Al) and titanium (Ti) are widely applied because of excellent abrasion resistance and heat resistance. In addition, nitride films mainly composed of Al and Ti and containing other metal elements have also been proposed. For example, Patent Document 1 discloses a coated cutting tool provided with a nitride film of AlTiW containing a tungsten (W) element.

### Citation List

### Patent Document

Patent Document 1: PCT International Publication No. WO2014/157688

### SUMMARY OF INVENTION

### Technical Problem

According to the studies of the inventors of the present invention, it has been confirmed that in the coated cutting tool provided with a nitride film mainly composed of Al and Ti, which has been proposed in the related art, there is room for improvement in durability.

### Solution to Problem

According to an aspect of the present invention, there is provided a coated cutting tool including: a substrate; and a hard film that is formed on the substrate, in which the hard film is a nitride in which with respect to a total amount of metal elements (including metalloid), Al is 60 at% or more and 70 at% or less, Ti is 20 at% or more and 40 at% or less, and one or more selected from W, Cr, Ta, Nb, Zr, Mo, and V are 1 at% or more and 10 at% or less, and with respect to a total amount of metal elements (including metalloid), a nitrogen element, and an Ar element, Ar is contained in an amount of 0.01 at% or more and 0.15 at% or less, and a crystal structure of the hard film is a face-centered cubic lattice structure, and a half-value width of an X-ray diffraction peak of a (111) plane is 0.75° or more and 0.95° or less.

It is preferable that the half-value width of the X-ray diffraction peak of the (111) plane of the hard film is 0.78° or more and 0.95° or less.

It is preferable that the hard film does not have a diffraction peak intensity corresponding to an AlN having a hexagonal closest-packed structure in an intensity profile of a selected area diffraction pattern using a transmission electron microscope. Advantageous Effects of Invention

According to the present invention, it is possible to provide a coated cutting tool having excellent durability.

### BRIEF DESCRIPTION OF DRAWINGS

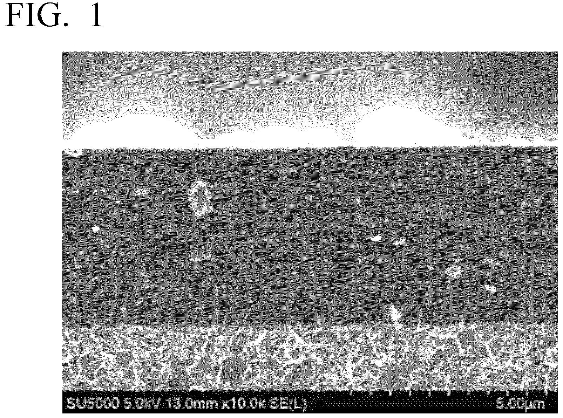

[FIG. 1] An example of a cross section observation photograph (×10,000 time) of a hard film according to Example 1 of the present invention.

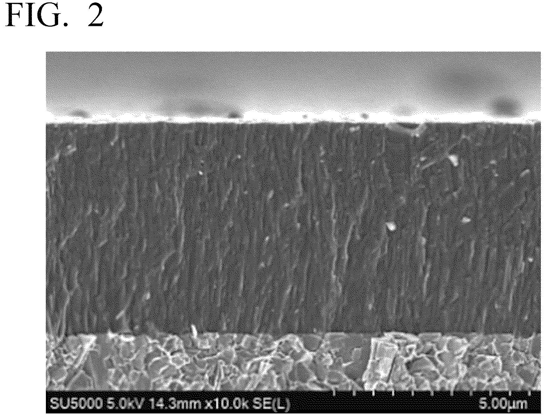

[FIG. 2] An example of a cross section observation photograph (×10,000 times) of a hard film according to Example 2 of the present invention.

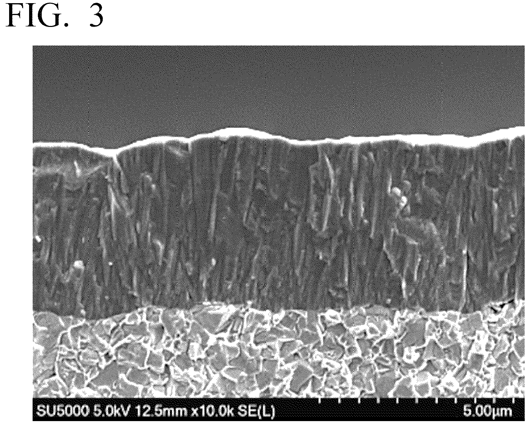

[FIG. 3] An example of a cross section observation photograph (×10,000 times) of a hard film according to Comparative Example 1.

### DESCRIPTION OF EMBODIMENTS

A coated cutting tool of the present embodiment includes a substrate, and a hard film that is formed on the substrate. The hard film according to the present embodiment is a nitride mainly composed of Al and Ti, which is a film type having excellent heat resistance and abrasion resistance. An intermediate film may be provided between the substrate and the hard film, as necessary. In addition, an upper layer may be provided on the hard film, as necessary. Hereinafter, the details will be described.

In the coated cutting tool of the present embodiment, the substrate is not particularly limited, and it is preferable that a WC-Co-based cemented carbide having excellent intensity and toughness is used as the substrate.

### <<Al>>

In the hard film according to the present embodiment, Al is 60 at% or more and 70 at% or less with respect to the total amount of metal elements (including metalloid, hereinafter, the same applies). Al is an element for improving the heat resistance of the hard film. The heat resistance of the hard film is increased by increasing the Al content of the hard film. In addition, by increasing the Al content of the hard film, an oxidation protective film is easily formed on the surface of the tool, making it easier to suppress damage to the film. In addition, by increasing the Al content of the hard film, a film structure becomes finer, making it easier to suppress damage to the film. In order to sufficiently exhibit these Al addition effects, in the hard film according to the present embodiment, the Al is set to 60 at% or more with respect to the total amount of the metal elements. In the hard film according to the present embodiment, Al is set to preferably 62 at% or more.

On the other hand, in a case where the Al content of the hard film is too large, an AlN having a fragile hexagonal closest-packed structure (hereinafter, a hcp structure) increases, so that the durability of the coated cutting tool is lowered. Therefore, in the hard film according to the present embodiment, Al is set to 70 at% or less with respect to the total amount of the metal elements. In the hard film according to the present embodiment, it is preferable that Al is set to 68 at% or less. In the hard film according to the present embodiment, it is further preferable that Al is set to 65 at% or less.

### <<Ti>>

In the hard film according to the present embodiment, Ti is set to 20 at% or more and 40 at% or less with respect to the total amount of the metal elements. In the hard film according to the present embodiment, when Ti is 20 at% or more with respect to the total amount of the metal elements, the crystal structure of the hard film becomes a face-centered cubic lattice structure, so that the durability of the coated cutting tool is improved. In addition, in the hard film according to the present embodiment, Ti is set to 40 at% or less with respect to the total amount of the metal elements, so that the heat resistance of the hard film is improved.

### <<One or more selected from W, Cr, Ta, Nb, Zr, Mo, and V>>

In the hard film according to the present embodiment, one or more selected from W, Cr, Ta, Nb, Zr, Mo, and V is 1 at% or more and 10 at% or less with respect to the total amount of the metal elements. These elements are transition metal elements belonging to Group 4a, Group 5a, or Group 6a of the periodic table, and are generally added to an AlTi nitride in order to improve film characteristics such as heat resistance, abrasion resistance, and lubricity. In order to sufficiently obtain the effect of improving the film characteristics due to the addition of these elements, in the hard film according to the present embodiment, one or more selected from W, Cr, Ta, Nb, Zr, Mo, and V is set to 1 at% or more with respect to the total amount of the metal elements. It is preferable that one or more selected from W, Cr, Ta, Nb, Zr, Mo, and V is set to 2 at% or more. It is further preferable that one or more selected from W, Cr, Ta, Nb, Zr, Mo, and V is set to 3 at% or more. On the other hand, in a case where the addition amount of the element other than Al and Ti is too large, the film characteristics of the hard film may deteriorate. Therefore, in the hard film according to the present embodiment, one or more selected from W, Cr, Ta, Nb, Zr, Mo, and V is set to 10 at% or less with respect to the total amount of the metal elements. It is preferable that one or more selected from W, Cr, Ta, Nb, Zr, Mo, and V is set to 8 at% or less. It is further preferable that one or more selected from W, Cr, Ta, Nb, Zr, Mo, and V is set to 6 at% or less. In particular, in cutting of high hardness steel, the durability of the coated cutting tool tends to become excellent by applying a hard film containing W, which is preferable.

### <<Ar>>

The hard film according to the present embodiment contains Ar in an amount of 0.01 at% or more and 0.15 at% or less with respect to the total amount of metal elements (including metalloid), a nitrogen element, and a Ar element (the entire hard film). The hard film according to the present embodiment is a hard film that is formed by a sputtering method. The hard film according to the present embodiment is a sputtered film, and is a sputtered hard film. The hard film that is formed by the sputtering method has a compressive residual stress, and has a smoother surface state than a hard film that is formed by an arc ion plating method with less droplets. In addition, in the sputtering method, since a target component is sputtered using an Ar ion to coat a hard film, Ar is contained in the hard film that is formed. The hard film according to the present embodiment contains Ar in an amount of 0.01 at% or more with respect to the total amount of the metal elements (including metalloid), the nitrogen elements, and the Ar elements (the entire hard film). In order to stabilize a coating process, in the hard film according to the present embodiment, it is preferable that Ar is set to 0.03 at% or more.

When a crystal grain size of the hard film becomes finer, hardness increases, whereas the number of crystal grain boundaries increases, and Ar contained in the hard film concentrates at the crystal grain boundaries. In a case where the Ar content of the hard film is large, the toughness of the hard film is lowered, and sufficient tool performance is difficult to exhibit. In order to reduce Ar that is concentrated at the crystal grain boundary of the hard film, in the hard film according to the present embodiment, Ar is set to 0.15 at% or less. In the hard film according to the present embodiment, it is preferable that Ar is set to 0.10 at% or less.

### <<Crystal Structure>>

The hard film according to the present embodiment has a face-centered cubic lattice structure (fcc structure). In the present embodiment, the fact that the hard film has a face-centered cubic lattice structure means that the hard film has only a diffraction peak intensity corresponding to the face-centered cubic lattice structure in X-ray diffraction of the hard film. That is, in the hard film of the present embodiment, in the X-ray diffraction, the diffraction peaks corresponding to the hcp structure and the bcc structure are not observed. A hard film having a diffraction peak intensity corresponding to the AlN having the hcp structure in the X-ray diffraction causes a decrease in durability of the coated cutting tool.

In the hard film according to the present embodiment, in the X-ray diffraction, a diffraction peak intensity of a (200) plane or a (111) plane of a face-centered cubic lattice structure is the maximum intensity among diffraction peak intensities of a plurality of observed diffraction peaks. In the hard film according to the present embodiment, it is preferable that a diffraction peak intensity of the (111) plane in the X-ray diffraction is the maximum intensity. The diffraction peak intensity of the (111) plane is the maximum intensity, so that the columnar structure of the hard film is likely to be finer.

It is preferable that the hard film according to the present embodiment does not have the diffraction peak intensity corresponding to the AlN having the hcp structure in the intensity profile of a selected area diffraction pattern using a transmission electron microscope. Even in a case of having no diffraction peak intensity corresponding to the AlN having the hcp structure in the X-ray diffraction, there is a case of having a diffraction peak intensity corresponding to the AlN having the hcp structure in the intensity profile of the selected area diffraction pattern using a transmission electron microscope. The hard film does not have the diffraction peak intensity corresponding to the AlN having the hcp structure in the intensity profile of the selected area diffraction pattern using the transmission electron microscope, so that the amount of the AlN having the hcp structure contained in a microstructure is reduced, and thus the durability of the coated cutting tool can be further improved.

### <<Half-value Width>>

In the hard film according to the present embodiment, it is important that the film structure is fine. The film structure is fine, making it easier to suppress tool damage in the processing of the high hardness steel. The inventors of the present invention have confirmed that there is a certain correlation between the value of the half-value width of the X-ray diffraction peak of the (111) plane, which is the closest-packed plane in a hard film having a face-centered cubic lattice structure, and the size of the columnar grain in the film structure. Then, in the composition range described above, it was confirmed that, by setting the half-value width of the X-ray diffraction peak of the (111) plane (FWHM: full width at half maximum) to 0.75° or more, the columnar grain of the hard film become fine and the durability of the coated cutting tool was also excellent. In the hard film according to the present embodiment, it is preferable that the half-value width of the X-ray diffraction peak of the (111) plane is 0.78° or more. In the hard film according to the present embodiment, it is further preferable that the half-value width of the X-ray diffraction peak of the (111) plane is 0.80° or more. On the other hand, in a case where the value of the half-value width is excessively large, an amorphous film structure is formed, and the AlN having the hcp structure is likely to increase. Therefore, in the hard film according to the present embodiment, the half-value width of the X-ray diffraction peak of the (111) plane is set to 0.95° or less. In the hard film according to the present embodiment, it is preferable that the half-value width of the X-ray diffraction peak of the (111) plane is 0.92° or less. In the hard film according to the present embodiment, it is further preferable that the half-value width of the X-ray diffraction peak of the (111) plane is 0.88° or less.

In the hard film according to the present invention, it is preferable that the half-value width of the X-ray diffraction peak on a (200) plane is 0.90° or more and 1.1° or less. In this way, a hard film having a face-centered cubic lattice structure which is a fine structure can be easily obtained.

The half-value width of the X-ray diffraction peak may be obtained under the measurement conditions of a tube voltage of 45 kV, a tube current of 40 mA, an X-ray source of CuKα (λ = 0.15405 nm), and 2θ in a range of 20 to 80 degrees, by using an X-ray diffractometer.

The hard film according to the present embodiment may contain other metal elements or metalloid elements within a range satisfying the composition and half-value width described above. For example, one or more metal elements or metalloid elements selected from Si, B, Cu, Y, and Yb may be contained. In a case of containing these elements, it is preferable that the content of each of these elements is 1 at% or more and 5 at% or less.

### <<Intermediate Film>>

The coated cutting tool according to the present embodiment may be provided with an intermediate film between the substrate and the hard film, as necessary. For example, a nitride, a carbonitride, or a carbide including one or more elements selected from Ti, Cr, and Al can be provided. In the coated cutting tool according to the present embodiment, the hard film may be provided directly on the substrate.

### <<Upper Layer>>

The coated cutting tool according to the present embodiment may be provided with an upper layer having a component ratio different from that of the hard film according to the present embodiment or a different composition, on the hard film according to the present embodiment, as necessary. The upper layer may be made of a plurality of layers or a laminated film.

In the coating of the hard film according to the present embodiment, it is preferable that among sputtering methods, a sputtering method in which electric power is sequentially applied to a target is applied and when a target to which electric power is applied is switched, electric power is simultaneously applied to both the target in which electric power application is ended and the target in which electric power application is started.

In a case where a time during which electric power is simultaneously applied to both an alloy target in which electric power application is ended and an alloy target in which electric power application is started is excessively short or long, the ionization of the target is not sufficient, and it is difficult to form a sufficient amount of nitride on the hard film. Therefore, it is preferable that the time during which electric power is simultaneously applied to both the alloy target in which electric power application is ended and the alloy target in which electric power application is started is 1 microsecond or longer and 20 microseconds or shorter. The maximum electric power density of an electric power pulse is preferably set to 0.5 kW/cm² or more. In order to increase the ionization rate of the target component, it is preferable to use three or more AlTiMe-based alloy targets (Me is one or more selected from W, Cr, Ta, Nb, Zr, Mo, and V). In order to form the hard film into a face-centered cubic lattice structure and to have a fine grain structure having high crystallinity, it is preferable that a film formation temperature is set to be in a range of 400°C to 460°C and a negative bias voltage that is applied to a cutting tool serving as a base is controlled in a range of -70 V to -40 V.

Hereinafter, the present invention will be described in more detail with reference to examples and comparative examples. However, the present invention is not limited to the following examples.

### Example 1

### <Tool>

As a tool serving as a substrate, a two-flute ball end mill made of cemented carbide (a tool diameter: 1.0 mm, manufactured by MOLDINO Co., Ltd.) having a composition of WC (bal.)-Co (8.0% by mass)-Ta (0.3% by mass), a WC average grain size of 0.5 µm, and hardness of 93.2 HRA (Rockwell hardness, a value measured based on JIS G 0202) was prepared.

A sputtering apparatus in which twelve sputtering vaporization sources can be mounted was used. Among these vapor deposition sources, six AlTiW alloy targets were installed in the apparatus as vapor deposition sources. A target having dimensions of a diameter of 16 cm and a thickness of 12 mm was used.

The tool was fixed to a sample holder in the sputtering apparatus and a bias power source was connected to the tool. The bias power source has a structure in which a negative bias voltage is applied to the tool independently of the target. The tool rotates at 3 revolutions per minute and revolves through a fixing jig and the sample holder. A distance between the tool and a target surface was set to 100 mm.

Ar and N₂ were used as introduction gases, and were introduced from a gas supply port provided in the sputtering apparatus.

### <Bombardment Treatment>

First, before the tool was coated with a hard film, bombardment treatment was performed on the tool in the following procedure. The inside of the sputtering apparatus was evacuated, and thereafter, heating was performed for 30 minutes in a state where the temperature in a furnace reached 430°C by a heater in the sputtering apparatus. Then, an Ar gas was introduced into the furnace of the sputtering apparatus. Then, a direct-current bias voltage was applied to the tool, and cleaning (bombardment treatment) of the tool by Ar ions was performed.

Next, an Ar gas and a nitrogen gas were introduced into the furnace of the sputtering apparatus to adjust the pressure in the furnace. A direct-current bias voltage was applied to the tool, a maximum electric power density of 0.8 kW/cm² was applied to the AlTiW alloy target, a discharge time per period of the electric power was set to 0.8 milliseconds, and a time during which the electric power was applied to the AlTiW alloy target was set to 4 microseconds. Then, a hard film having a total film thickness of about 3 µm was formed by continuously applying electric power to each alloy target. Details of the film-forming conditions are shown in Table 1.

**[Table 1]**

| Sample No. | Target composition (at%) | Film-forming temperature (°C) | Bias voltage applied to substrate (V) | P_{Ar} (Pa) | P_{N2} (Pa) |
|---|---|---|---|---|---|
| Example 1 | Al66Ti29W5 | 430 | -60 | 0.43 | 0.32 |
| Example 2 | Al66Ti29W5 | 450 | -40 | 0.43 | 0.32 |
| Comparative Example 1 | Al66Ti29W5 | 430 | -40 | 0.43 | 0.32 |
| Comparative Example 2 | Al68Ti27W5 | 300 | -40 | 0.43 | 0.32 |
| Comparative Example 3 | Al68Ti27W5 | 300 | -40 | 0.20 | 0.11 |
| Comparative Example 4 | Al66Ti29W5 | 430 | -80 | 0.43 | 0.32 |
| Comparative Example 5 | Al66Ti29W5 | 480 | -40 | 0.43 | 0.32 |
| Comparative Example 6 | Al66Ti29W5 | 480 | -80 | 0.43 | 0.32 |
| Comparative Example 7 | Al68Ti27W5 | 430 | -40 | 0.10 | 0.18 |
| Comparative Example 8 | Al66Ti29W5 | 430 | -120 | 0.43 | 0.32 |

The hardness and the elastic modulus of the hard film were measured using a nanoindentation tester (ENT-2100 manufactured by Elionix Inc.).

Confirmation was performed using an X-ray diffractometer (EMPYREAN manufactured by PaNalytical Corporation) under measurement conditions of a tube voltage of 45 kV, a tube current of 40 mA, an X-ray source of Cuk α (λ = 0.15405 nm), and 20 in a range of 20 to 80 degrees.

A film composition of the hard film was measured by a wavelength-dispersive electron probe micro-analyzer (WDS-EPMA) attached to an electron probe microanalyzer (JXA-8500F manufactured by JEOL Ltd.). The measurement conditions were set to an acceleration voltage of 10 kV, an irradiation current of 5 × 10⁻⁸ A, and an incorporation time of 10 seconds, and an analysis region was measured at five points in a range of a diameter of 1 µm, and the metal content ratio of the hard film and the content ratio of Ar with respect to the total amount of the metal element, the nitrogen element, and the Ar element were obtained from the average value of the five-point measurement. The results of the characteristic evaluation are shown in Table 2.

**[Table 2]**

| Sample No. | Hard film (at%) | Ar (at%) | Crystal structure | (111)/ (200) | FWHM (111) (°) | FWHM (200) (°) | Hardness (GPa) | Elastic modulus (GPa) |
|---|---|---|---|---|---|---|---|---|
| Example 1 | (Al64Ti31W5) N | 0.06 | fcc | 1.3 | 0.83 | 1.09 | 30 | 502 |
| Example 2 | (Al63Ti32W5) N | 0.06 | fcc | 0.8 | 0.75 | 1.02 | 31 | 517 |
| Comparative Example 1 | (Al63Ti32W5) N | 0.06 | fcc | 2.0 | 0.59 | 0.98 | 31 | 497 |
| Comparative Example 2 | (Al67Ti28W5) N | 0.13 | fcc + hcp | 0.9 | 1.43 | 1.33 | 23 | 357 |
| Comparative Example 3 | (A163Ti31W6) N | 0.27 | fcc + hcp | - | - | - | 19 | 244 |
| Comparative Example 4 | (Al64Ti31W5) N | 0.15 | fcc + hcp | 0.8 | 0.87 | 1.10 | 29 | 443 |
| Comparative Example 5 | (Al64Ti31W5) N | 0.15 | fcc + hcp | 1.4 | 0.77 | 0.79 | 31 | 497 |
| Comparative Example 6 | (Al64Ti31W5) N | 0.15 | fcc + hcp | 0.6 | 0.92 | 1.13 | 32 | 518 |
| Comparative Example 7 | (Al67Ti28W5) N | 0.15 | fcc + hcp | 1.7 | 1.73 | 1.22 | 23 | 436 |
| Comparative Example 8 | (Al63Ti32W5) N | 0.14 | fcc + hcp | 0.5 | 0.98 | 1.21 | 31 | 488 |

### <<Cutting Conditions>>

With respect to the produced coated cutting tool, a dry cutting test and a wet cutting test were performed under the cutting conditions shown below. Results of the cutting tests are shown in Table 3. Details of the cutting conditions are as follows.

### <Processing Conditions>

· Cutting method: bottom cutting
   Work material: STAVAX (52HRC)
   Tool used: two-flute ball end mill (tool diameter: 1.0 mm and neck length: 6 mm)
· Depth of cut: 0.04 mm in the axial direction, and 0.04 mm in the radial direction
· Cutting speed: 75 m/min,
   One blade feed amount: 0.018 mm/blade
· Cutting distance: dry = 60 m, wet = 40 m

The wet processing was carried out by directly applying a water-soluble cutting oil diluted to about 10% concentration to a location of the work material to be processed by a tool through a coolant hose.

**[Table 3]**

| Sample No. | Wet cutting test (maximum abrasion width mm) | Dry cutting test (maximum abrasion width mm) |
|---|---|---|
| Example 1 | 0.014 | 0.017 |
| Example 2 | 0.020 | 0.025 |
| Comparative Example 1 | 0.025 | 0.030 |
| Comparative Example 2 | 0.018 | Peeling at 5 m |
| Comparative Example 3 | 0.025 | Peeling at 5 m |
| Comparative Example 4 | 0.019 | Peeling at 5 m |
| Comparative Example 5 | 0.017 | Peeling at 5 m |
| Comparative Example 6 | 0.018 | Peeling at 5 m |
| Comparative Example 7 | 0.023 | Peeling at 5 m |
| Comparative Example 8 | Peeling at 5 m | Peeling at 5 m |

In all of the comparative examples in which the crystal structure includes the hcp structure, film peeling occurred at an early stage in the wet cutting test, and thus continuous processing could not be performed. In the cutting processing, extremely high cutting heat is generated at a contact portion between the tool and the work material. Expansion and contraction of the tool due to the cutting heat often cause tool damage called a hot crack. This is more remarkably observed in a wet processing having a high cooling effect. Therefore, in the wet processing, it is presumed that the comparative examples including a vulnerable hcp structure caused the film peeling at an early stage.

In Comparative Example 8, early film peeling occurred even in the dry cutting test in which the absolute value of the negative bias voltage that is applied to the substrate at the time of coating of the hard film is large and excessive residual compressive stress is applied to the hard film.

In addition, in Comparative Example 1 in which the crystal structure does not include the hcp structure, although early film peeling did not occur in the wet cutting test, the maximum abrasion width increased because the film structure was slightly coarse as compared with the examples of the present invention.

On the other hand, in the examples of the present invention, excellent durability was shown in both the wet cutting test and the dry cutting test. In particular, in Example 1 in which the hard film was made finer, in any of the cutting tests, the maximum abrasion width was small and the abrasion resistance was excellent, and the coated cutting tool had excellent durability.

## Claims

1. A coated cutting tool comprising:
a substrate; and
a hard film that is formed on the substrate,
wherein the hard film is a nitride in which with respect to a total amount of metal elements (including a metalloid), Al is 60 at% or more and 70 at% or less, Ti is 20 at% or more and 40 at% or less, and one or more selected from W, Cr, Ta, Nb, Zr, Mo, and V are 1 at% or more and 10 at% or less, and with respect to a total amount of metal elements (including metalloid), a nitrogen element, and an Ar element, Ar is contained in an amount of 0.01 at% or more and 0.15 at% or less, and
a crystal structure of the hard film is a face-centered cubic lattice structure, and a half-value width of an X-ray diffraction peak of a (111) plane is 0.75° or more and 0.95° or less.

2. The coated cutting tool according to Claim 1, wherein the half-value width of the X-ray diffraction peak of the (111) plane of the hard film is 0.78° or more and 0.95° or less.

3. The coated cutting tool according to Claim 1 or 2, wherein the hard film does not have a diffraction peak intensity corresponding to an AlN having a hexagonal closest-packed structure in an intensity profile of a selected area diffraction pattern using a transmission electron microscope.
